# EUROPEAN PATENT SPECIFICATION

(11) **EP 3 920 677 B1**
(45) Date of publication and mention of the grant of the patent: **05.04.2023**
(21) Application number: 19912716.8
(22) Date of filing: 01.02.2019
(51) Int. Cl.: H05K 13/08

(54) **WORK MACHINE**
ARBEITSMASCHINE
MACHINE DE TRAVAIL

(43) Date of publication of application: 08.12.2021
(73) Proprietor: Fuji Corporation, Chiryu-shi, Aichi 472-8686 (JP)
(72) Inventor: MATSUDA, Futoshi, Chiryu-shi, Aichi 472-8686 (JP)
(74) Representative: Grünecker Patent- und Rechtsanwälte PartG mbB
(86) International application number: PCT/JP2019/003686
(87) International publication number: WO 2020/157971

(56) References cited:
- WO-A1-98/26641
- JP-A- 2000 236 200
- JP-A- 2004 146 484
- JP-A- 2012 084 935
- JP-A1- O2017 085 816

## Description

### Technical Field

The present invention relates to a work machine which performs an operation with a component.

### Background Art

In a work machine that performs an operation with a component, information related to the component is acquired as described in the following Patent Literature.

Patent Application JP 2017 85816 A relates to mounting of components on a surface of a circuit board, with the components having a plurality of identification codes. A wafer pallet includes a component holding sheet held between a lower ring and upper ring. The rings have a bar code placed at their respective upper surface. A code reading section is arranged downward, so as to face the upper surface of the wafer, and reads the bar codes. A mounting nozzle picks up a component from the upper surface.

### Patent Literature

Patent Literature 1: JP-A-2005-109287

### Summary of the Invention

### Technical Problem

An object of the present disclosure is to appropriately obtain information on a component that is used in a work machine performing an operation with the component.

### Solution to Problem

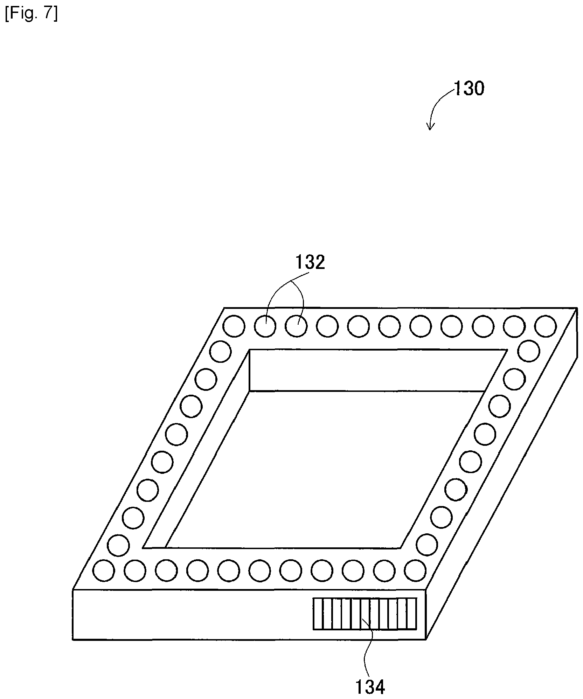

The above-mentioned problem is solved by the present invention defined by the features of the independent claim, with preferred embodiments being specified in the dependent claims. References to embodiments which do not fall under the scope of the claims are to be understood as examples useful for understanding the invention. The claims are directed to Fig. 7.

### Advantageous Effect of the Invention

According to the present disclosure, identification information for identifying a component, the information of which being attached to a side surface of the component, is read by a reading device. In this manner, it is possible to appropriately obtain information on a component.

### Brief Description of Drawings

[Fig. 1] Fig. 1 is a perspective view illustrating a component mounter.
[Fig. 2] Fig. 2 is a perspective view illustrating a component mounting device.
[Fig. 3] Fig. 3 is an enlarged perspective view illustrating a mark camera and a bar code reader.
[Fig. 4] Fig. 4 is a block diagram showing a control device.
[Fig. 5] Fig. 5 is a perspective view illustrating a component with a bar code being attached on an upper surface thereof.
[Fig. 6] Fig. 6 is a perspective view illustrating a component with a bar code being attached on a lower surface thereof.
[Fig. 7] Fig. 7 is a perspective view illustrating a component with a bar code being attached to a side surface thereof.

### Description of Embodiments

Hereinafter, as exemplary embodiments of the present invention, an embodiment of the present invention will be described in detail with reference to the drawings.

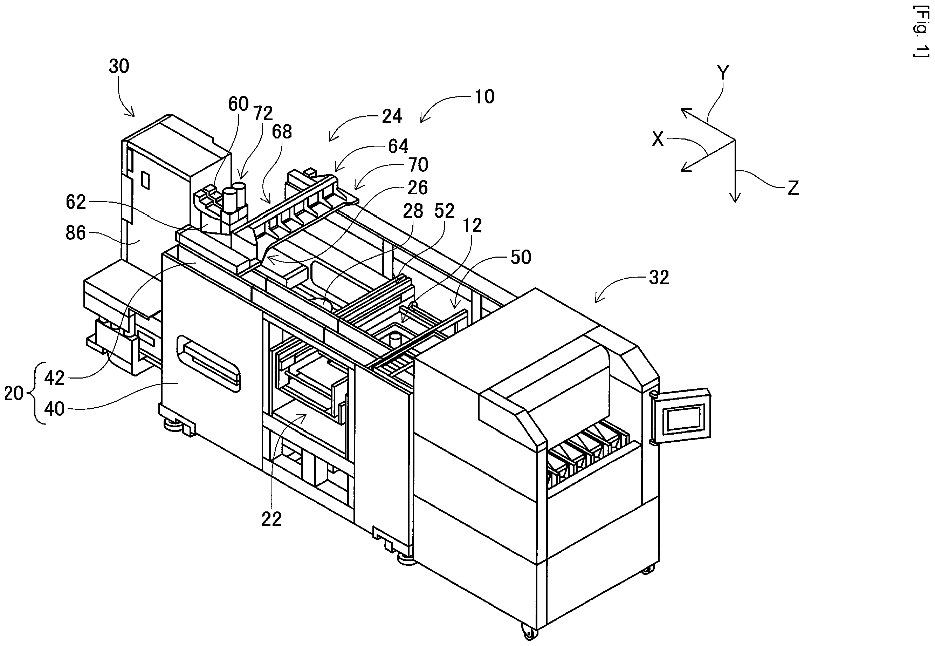

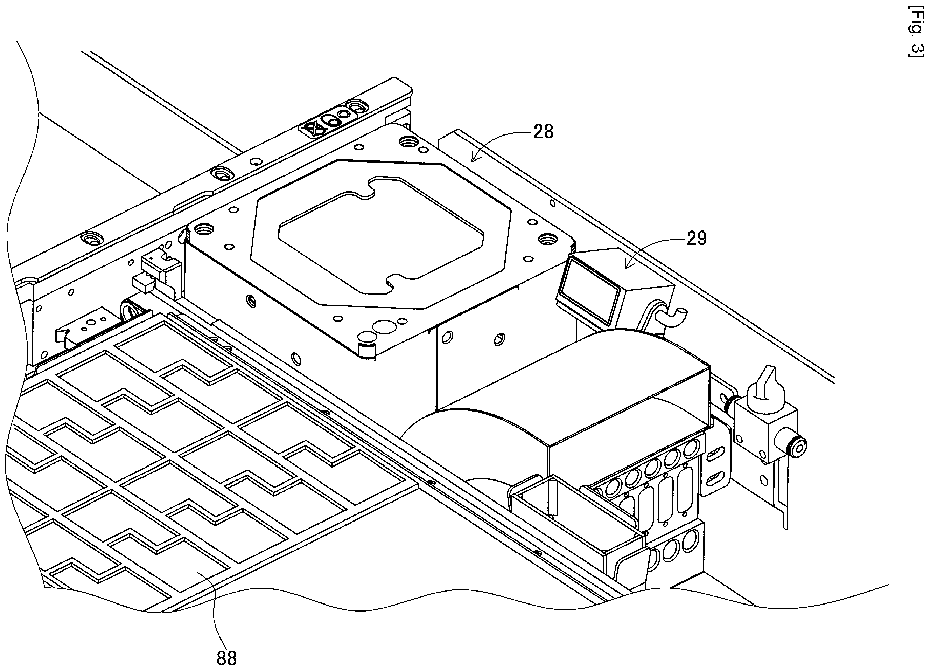

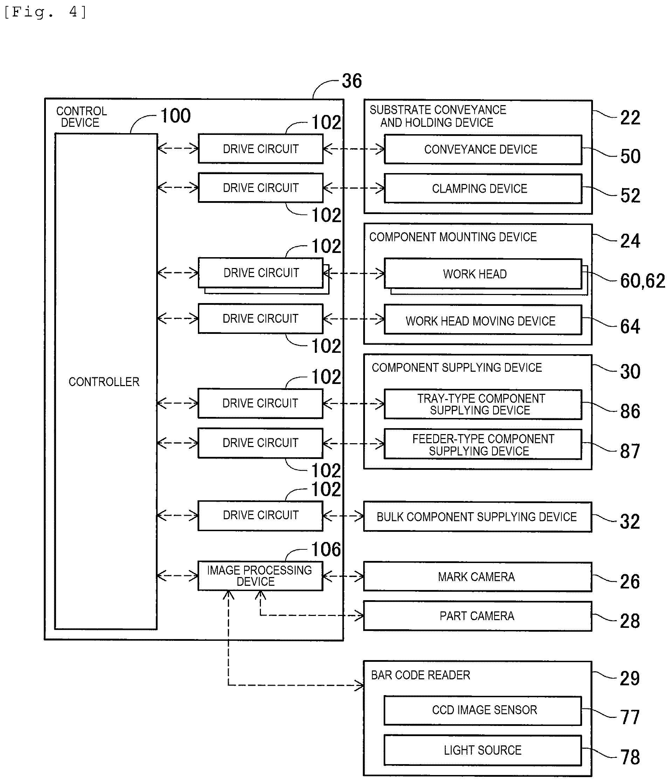

Fig. 1 shows component mounter 10. Component mounter 10 is a device that performs a mounting work of a component on circuit substrate 12. Component mounter 10 includes device main body 20, a substrate conveyance and holding device 22, component mounting device 24, mark camera 26, part camera 28, bar code reader (refer to Fig. 3) 29, component supplying device 30, bulk component supplying device 32, and control device 36(refer to Fig. 4). Examples of circuit substrate 12 include a circuit board, and a substrate with a three-dimensional structure and the like, and examples of a circuit board include a printed wiring board or a printed circuit board and the like.

Device main body 20 is configured of frame 40 and beam 42 provided on frame 40. Substrate conveyance and holding device 22 is disposed at the center of frame 40 in the forward-rearward direction, and includes conveyance device 50 and clamping device 52. Conveyance device 50 is a device that conveys circuit substrate 12, and clamping device 52 is a device that holds circuit substrate 12. In this manner, substrate conveyance and holding device 22 conveys circuit substrate 12 and fixedly holds circuit substrate 12 at a predetermined position. In the following description, the conveyance direction of circuit substrate 12 is referred to as the X-direction, the horizontal direction perpendicular to the X-direction is referred to as the Y-direction, and the vertical direction is referred to as the Z-direction. That is, the width direction of component mounter 10 is the X-direction, and the forward-rearward direction is the Y-direction.

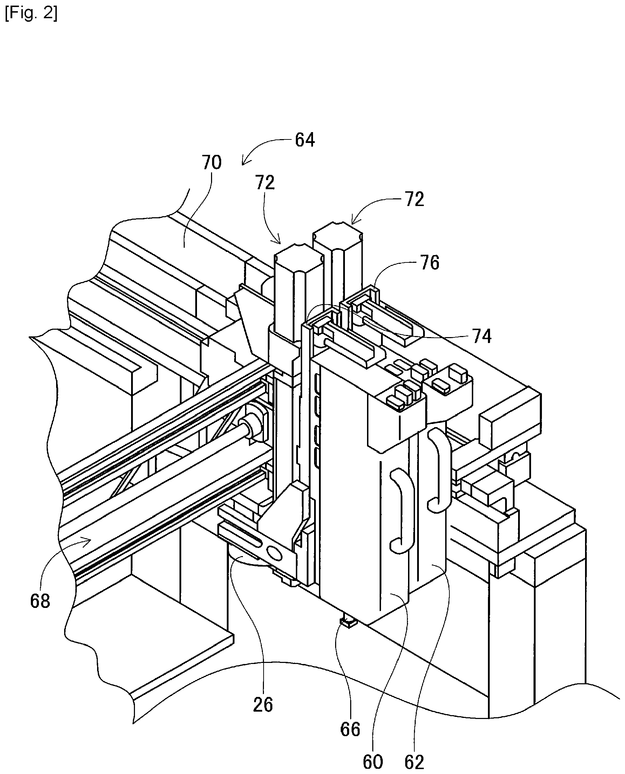

Component mounting device 24 is disposed on beam 42, and includes two work heads, work head 60 and 62, and work head moving device 64. As illustrated in Fig. 2, suction nozzle 66 is detachably provided on a lower end face of each work head 60 and 62, with a component held by suction nozzle 66. In addition, work head moving device 64 has X-direction moving device 68, Y-direction moving device 70, and Z-direction moving device 72. Then, X-direction moving device 68 and Y-direction moving device 70 respectively have an electromagnetic motor (not illustrated) so that two work heads, work head 60 and 62 integrally move to any positions on frame 40 by the operation of each electromagnetic motor. Further, each work head 60 and 62 is detachably mounted to sliders 74 and 76, and Z-direction moving device 72 individually moves sliders 74 and 76 in the up-down direction. That is, work heads 60 and 62 are individually moved in the upward-downward direction by Z-direction moving device 72.

Mark camera 26 is attached to slider 74 in a state of facing downward, and is moved to the X-direction, Y-direction, and Z-direction together with work head 60. In this manner, mark camera 26 can capture an image of any position on frame 40 from the viewpoint above. As illustrated in Fig. 1, part camera 28 is disposed in a state of facing upward between substrate conveyance and holding device 22 and component supplying device 30 on frame 40. In this manner, part camera 28 is enabled to image a component held by suction nozzle 66 of work heads 60 and 62 from the viewpoint from the bottom side.

As illustrated in Fig. 3, bar code reader 29 is disposed adjacent to part camera 28. Bar code reader 29 is a CCD-type bar code reader, and executes a bar code reading operation using the CCD image sensor. More specifically, bar code reader 29 includes CCD image sensor (refer to Fig. 4) 77 and light source (refer to Fig. 4) 78 so that light is irradiated from light source 78 to the bar code of the target to be read. At this time, CCD image sensor 77 receives the reflected light to create image data. Then, the image data is decoded in accordance with the rules of the bar code, hence the operation of reading the bar code is executed. That is, bar code reader 29 images the bar code by a front light method using reflected light instead of a backlight method using transmitted light, and performs a bar code reading operation based on the image data.

Incidentally, in the backlight method, a light source is disposed so that light is directly incident on a CCD image sensor, and a subject is disposed between a CCD image sensor and a light source. Then, the shadow of the subject is imaged. Therefore, even if a bar code is imaged as the subject by the backlight method, it is impossible to perform a bar code reading operation. On the other hand, using the front light method, the light source is disposed such that the light irradiated on the subject enters the CCD image sensor as reflected light. Therefore, in case a bar code is imaged as a subject by the front light method, it is possible to appropriately perform a bar code reading operation.

Bar code reader 29 is inclined slightly obliquely upward, and is disposed in the state of facing the side. Therefore, bar code reader 29 can image the components held by suction nozzles 66 of work heads 60 and 62 from the side viewpoint.

As illustrated in Fig. 1, component supplying device 30 is disposed at one end portion of frame 40 in the forward-rearward direction. Component supplying device 30 includes tray-type component supplying device 86 and feeder-type component supplying device 87 (refer to Fig. 4). Tray-type component supplying device 86 houses multiple trays in the tower, and discharges any of the trays from the tower. At this time, as illustrated in Fig. 3, tray 88 is discharged to the side of part camera 28 and bar code reader 29. Then, components in a state of being placed on tray 88, for example, tray components such as large-sized components or odd-shaped components are supplied. In addition, feeder-type component supplying device 87 supplies components, for example, feeder components such as small-sized components or corner chips, by a tape feeder and a stick feeder (not illustrated).

As illustrated in Fig. 1, bulk component supplying device 32 is disposed at the other end portion of frame 40 in the forward-rearward direction. Bulk component supply device 32 is a device that aligns multiple scattered components to supply the components in an aligned state. That is, bulk component supplying device 32 aligns multiple components being arbitrarily postured into a predetermined posture to supply components in the predetermined posture.

As illustrated in Fig. 4, control device 36 includes controller 100, multiple drive circuits 102, and image processing device 106. Multiple drive circuits 102 are connected to conveyance device 50, clamping device 52, work heads 60 and 62, work head moving device 64, tray-type component supplying device 86, feeder-type component supplying device 87, and bulk component supplying device 32. Controller 100, including CPU, ROM, RAM and the like, which is mainly composed of a computer and connected to multiple drive circuits 102. In this manner, the operations of substrate conveyance and holding device 22, and component mounting device 24 and the like, are controlled by controller 100. The controller is also connected to the image processing device 106. Image processing device 106 is configured to process image data obtained with mark camera 26, part camera 28, and bar code reader 29. In this manner, controller 100 acquires various types of information from the image data.

Component mounter 10 configured as described above performs a component mounting operation on circuit substrate 12 held by substrate conveyance and holding device 22. Specifically, circuit substrate 12 is conveyed to a work position, and is fixedly held by clamp device 52 at that position. Next, mark camera 26 is moved to a position above circuit substrate 12 and images circuit substrate 12. In this way, information about the error in the holding position of circuit substrate 12 is obtained. In addition, component supplying device 30 or bulk component supplying device 32 supplies components at predetermined supply positions. One of work heads 60 or 62 is then moved above the component supply position and holds the component with suction nozzle 66.

Subsequently, work head 60 or 62 holding the component moves above part camera 28, and the component held with suction nozzle 66 is imaged by part camera 28. In this manner, information on the error in the holding position of a component is obtained. Then, work head 60 or 62 holding the component moves above circuit substrate 12, and corrects errors such as in the holding position of circuit substrate 12 and in the holding position of the component, and mounts the component on circuit substrate 12.

As described above, in component mounter 10, a component supplied by component supplying device 30 and the like is mounted on circuit substrate 12, whereby an electronic circuit board configured by electronic components and the like, is manufactured. A component to be mounted on circuit substrate 12 is attached with a bar code in which identification information of the component is recorded. The identification information recorded in the bar code is information indicating a manufacturing number unique to a component and the like, and can manage a manufacturing factory, a manufacturing date and time of a component based on the identification information. Therefore, when an electronic circuit board is manufactured by component mounter 10, the identification information of the components constituting the electronic circuit board is read by bar code reader 29 and the like, and stored in control device 36 as traceability information. Incidentally, components constituting electronic circuit boards are not limited only to electronic components, but a cover, a raising member and the like may be also employed.

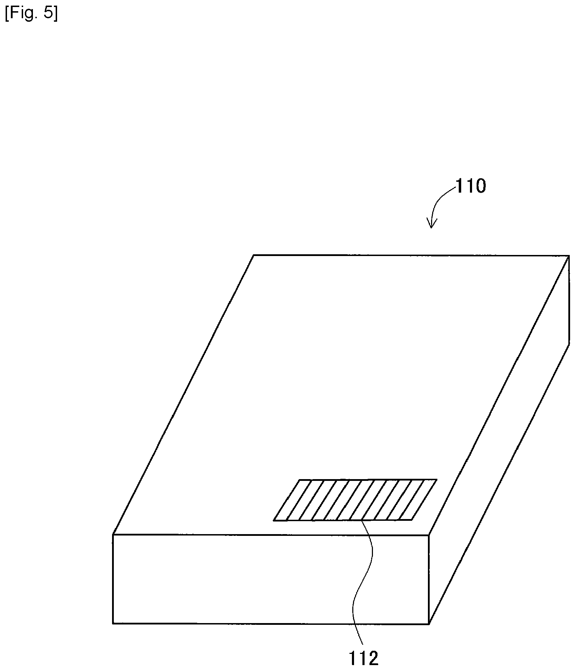

Specifically, for example, as illustrated in Fig. 5, bar code 112 is attached to an upper surface of substantially rectangular parallelepiped-shaped component 110. Component 110 is placed on tray 88 and supplied in tray-type component supplying device 86 in a state in which bar code 112 is directed upward. Therefore, in a state where component 110 is placed on tray 88, before component 110 is held by suction nozzle 66, an image of bar code 112 attached to the upper surface of component 110 is captured by mark camera 26. Then, by decoding the image data by image processing device 106, controller 100 acquires the identification information of component 110, and stores the identification information as traceability information. The expression "attached" in the present specification is a concept including attachment, description, and stamping.

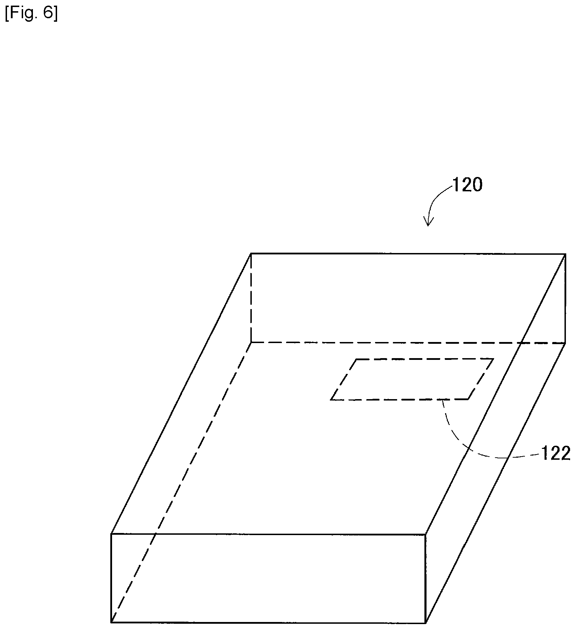

For example, in case there is no space on the upper surface of the component to which a bar code is attached, bar code 122 is attached to the lower surface of component 120 as illustrated in Fig. 6. Component 120 is placed on tray 88 and supplied in tray-type component supplying device 86 in a state in which bar code 122 is directed downward. Therefore, bar code 122 cannot be imaged by mark camera 26 in a state where component 120 is placed on tray 88. Therefore, after component 120 is held by suction nozzle 66, suction nozzle 66 moves above part camera 28 by the operation of work head moving device 64 so that bar code 122 attached to the lower surface of component 120 is imaged by part camera 28. Then, by decoding the image data by image processing device 106, controller 100 acquires the identification information of component 120, and stores the identification information as traceability information. Together with the imaging of bar code 122, component 120 is also imaged so that information as to the error in the holding position of the component is also obtained based on the imaging data of component 120. That is, by capturing an image of component 120 held by suction nozzle 66 by part camera 28, controller 100 acquires the identification information of component 120 and the information as to the error in the holding position of component.

In addition, component 130 illustrated in Fig. 7 has a generally frame shape, multiple bumps 132 are disposed on an upper surface of component 130, and multiple bumps (not illustrated) are also disposed on a lower surface of component 130. Therefore, there is no space for attaching a bar code on the upper surface and the lower surface of component 130. Therefore, bar code 134 is attached to a side surface of component 130. Component 130 is placed on tray 88 and supplied in tray-type component supplying device 86 in a state in which bar code 134 is directed toward the side. Therefore, in a state where component 130 is placed on tray 88, bar code 134 cannot be imaged by mark camera 26. In addition, even in a state where component 130 is held by suction nozzle 66, bar code 134 cannot be imaged by part camera 28. Therefore, after component 130 is held by suction nozzle 66, suction nozzle 66 moves to the side of bar code reader 29 by the operation of work head moving device 64, whereby bar code 134 attached to the side surface of component 130 is read by bar code reader 29. That is, by capturing an image of bar code 134 by bar code reader 29 and decoding the image data by image processing device 106, controller 100 acquires the identification information of component 130, and stores the identification information as traceability information. The side surface in the present specification is a surface facing the side, and is a concept including a surface facing obliquely upward and obliquely downward.

The reading operation of bar code 134 by bar code reader 29 and the imaging work of component 130 by part camera 28 are continuously performed. In detail, after component 130 is held by suction nozzle 66 from the top of tray 88, for example, by the operation of work head moving device 64, suction nozzle 66 moves to the side of bar code reader 29 so that an image of bar code 134 is imaged by bar code reader 29. After the imaging of bar code 134 is completed, suction nozzle 66 moves above part camera 28 by the operation of work head moving device 64 so that component 130 is imaged by part camera 28. In addition, after component 130 is held by suction nozzle 66 off the top of tray 88, for example, by the operation of work head moving device 64, suction nozzle 66 moves above part camera 28 so that component 130 is imaged by part camera 28. After the imaging of component 130 is completed, suction nozzle 66 moves to the side of bar code reader 29 by the operation of work head moving device 64 so that bar code 134 is imaged by bar code reader 29.

As described above, the reading operation of bar code 134 by bar code reader 29 and the imaging work of component 130 by part camera 28 are continuously performed so that the takt time can be shortened. This is because part camera 28 and bar code reader 29 are disposed adjacent to each other. That is, bar code reader 29 adjacent to part camera 28 faces a location that is slightly deviated from the upper side to the side of part camera 28. Therefore, the positions of work heads 60 or 62 at the time of the imaging work of the component by part camera 28 and the positions of work heads 60 or 62 at the time of the reading operation of the bar code by bar code reader 29 are very close to each other. In this manner, by continuously performing the reading operation of bar code 134 by bar code reader 29 and the imaging work of component 130 by part camera 28, the movement time of work heads 60 and 62 can be shortened so that the takt time can be shortened.

In other words, part camera 28 and bar code reader 29 are disposed on the flow lines of work heads 60 and 62 during mounting operations. That is, part camera 28 and bar code reader 29 are disposed between component supply device 30 and substrate conveyance and holding device 22. Therefore, the imaging work by part camera 28 and the bar code reading operation by bar code reader 29 are performed while work heads 60 and 62 holding the components from component supplying device 30 move above circuit substrate 12 held by substrate conveyance and holding device 22. In this manner, it is possible to further shorten the takt time.

Component mounter 10 is an example of a work machine. Part camera 28 is an example of an imaging device. bar code reader 29 is an example of a reading device. Suction nozzle 66 is an example of a holding tool.

In the above embodiment, bar code 134 is directly read by bar code reader 29, but may be indirectly read. Specifically, for example, bar code 134 may be projected on a mirror, and a mirror image projected on the mirror may be read by bar code reader 29. By using such a method, bar code 134 can be read by bar code reader 29 in a state in which bar code reader 29 is directed not in the side direction, but in another direction such as an upward direction and a downward direction.

In the above embodiment, CCD type bar code reader 29 is employed, but a laser type bar code reader may be employed. The laser-type bar code reader scans bar code 134 with laser light, and receives the reflected light by a light receiving element such as a photo diode. Then, the bars and spaces constituting bar code 134 are recognized from the waveforms of the received light, and are decoded according to the rules of the bar code, whereby the bar code reading operation is performed. In addition, as long as it is a device capable of reading bar code 134, an imaging device such as part camera 28 may be employed instead of the bar code reader.

In the above embodiment, the present invention is applied to a component to be mounted on circuit substrate 12, that is, a component constituting the electronic circuit board, but the present invention can be applied to various components. Specifically, the present invention can be applied to, for example, components constituting an article manufactured by assembling multiple components.

### Reference Signs List

10: component mounter (work machine), 28: part camera (imaging device), 29: bar code reader (reading device), 66: suction nozzle (holding tool)

## Claims

1. A work machine (10)
**characterized by** the work machine including
a holding tool (66) configured to hold a bulk component (130) on a top surface of the bulk component;
a reading device (29) being disposed in a state facing a side surface of the bulk component different from the top surface and a bottom surface of the bulk component, and configured to:
- read identification information (134), being attached to the side surface, from the side surface;
- identify the bulk component, and
- perform a reading operation of the identification information with the reading device.

2. The work machine according to claim 1, wherein the work machine includes an image device (28) for imaging from below the bulk component held by the holding tool, and wherein the reading device is disposed adjacent to the imaging device.

3. The work machine according to claim 2, wherein an imaging work of the bulk component by the imaging device and a reading operation of the identification information by the reading device are continuously performed.

## Patentansprüche

1. Bearbeitungsmaschine (10),
**dadurch gekennzeichnet, dass** die Bearbeitungsmaschine enthält:
ein Haltewerkzeug (66), das so ausgeführt ist, dass es ein loses Bauteil (130) an einer oberen Fläche des losen Bauteils hält;
eine Lesevorrichtung (29), die in einem Zustand angeordnet ist, in dem sie einer seitlichen Fläche des losen Bauteils zugewandt ist, die sich von der oberen Fläche und einer unteren Fläche des losen Bauteils unterscheidet, und die so ausgeführt ist, dass sie:
- Identifikations-Informationen (134), die an der seitlichen Fläche aufgebracht sind, von der seitlichen Fläche liest;
- das lose Bauteil identifiziert, und
- einen Vorgang zum Lesen der Identifikations-Informationen mit der Lesevorrichtung durchführt.

2. Bearbeitungsmaschine nach Anspruch 1, wobei die Bearbeitungsmaschine eine Abbildungsvorrichtung (28) zum Abbilden des von dem Haltewerkzeug gehaltenen losen Bauteils von unten einschließt und die Lesevorrichtung benachbart zu der Abbildungsvorrichtung angeordnet ist.

3. Arbeitsmaschine nach Anspruch 2, wobei ein Vorgang zum Abbilden des losen Bauteils durch die Abbildungsvorrichtung und ein Vorgang zum Lesen der Identifikations-Informationen durch die Lesevorrichtung kontinuierlich durchgeführt werden.

## Revendications

1. Machine de travail (10)
**caractérisée par** la machine de travail incluant
un outil de maintien (66) configuré pour maintenir un composant en masse (130) sur une surface supérieure du composant en masse ;
un dispositif de lecture (29) disposé dans un état orienté vers une surface latérale du composant en masse différente de la surface supérieure et d'une surface inférieure du composant en masse, et configuré pour :
lire des informations d'identification (134), rattachées à la surface latérale, depuis la surface latérale ;
identifier le composant en masse, et
effectuer une opération de lecture des informations d'identification avec le dispositif de lecture.

2. La machine de travail selon la revendication 1, dans laquelle la machine de travail inclut un dispositif d'imagerie (28) pour prendre une image depuis le dessous du composant en masse maintenu par l'outil de maintien, et dans laquelle le dispositif de lecture est disposé adjacent au dispositif d'imagerie.

3. La machine de travail selon la revendication 2, dans laquelle un travail d'imagerie du composant en masse par le dispositif d'imagerie et une opération de lecture des informations d'identification par le dispositif de lecture sont effectuées en continu.
